**Europäisches Patentamt**

**European Patent Office**

**Office européen des brevets**

(19)

(11) Numéro de publication: **0 289 063 B1**

(12) **FASCICULE DE BREVET EUROPEEN**

(45) Date de publication de fascicule du brevet: **10.06.92**

(51) Int. Cl.5: **G11C 8/00**

(21) Numéro de dépôt: **88200541.6**

(22) Date de dépôt: **23.03.88**

(54) **Mémoire comportant un décodeur de lignes pourvu d'un étage de commutation du type Darlington.**

(30) Priorité: **27.03.87 FR 8704301**

(43) Date de publication de la demande:
**02.11.88 Bulletin 88/44**

(45) Mention de la délivrance du brevet:
**10.06.92 Bulletin 92/24**

(84) Etats contractants désignés:
**DE FR GB IT NL**

(56) Documents cités:
**EP-A- 0 200 255**
**DE-A- 2 658 523**
**US-A- 4 168 490**

**PATENT ABSTRACTS OF JAPAN, vol. 8, no. 79 (P-267)[1516], 11 avril 1984; & JP-A-58 222 488**

(73) Titulaire: **PHILIPS COMPOSANTS**
**117, quai du Président Roosevelt**
**F-92130 Issy les Moulineaux(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB IT NL**

(72) Inventeur: **Barbu, Stefan Societe Civile S.P.I.D.**
**209, rue de l'Université**
**F-75007 Paris(FR)**
Inventeur: **Imbert, Guy Societe Civile S.P.I.D.**
**209, rue de l'Université**
**F-75007 Paris(FR)**

(74) Mandataire: **Charpail, François et al**
**Société Civile S.P.I.D. 156, Boulevard Haussmann**
**F-75008 Paris(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention a pour objet une mémoire comportant un décodeur de lignes pourvu pour chaque ligne d'un étage de commutation de ligne du type Darlington comportant un premier transistor dont la base, qui constitue l'entrée de l'étage, est susceptible de recevoir un signal logique de commande dont la tension varie entre un niveau dit de sélection et un niveau dit de non sélection, et dont l'émetteur attaque la base d'un deuxième transistor dont l'émetteur, qui constitue la sortie de l'étage, est relié à un conducteur de ligne supérieur, dans lequel circule un premier courant lorsque ledit signal logique de commande est à son niveau de sélection et un deuxième courant plus faible que le premier lorsque ledit signal logique de commande est à son niveau de non-sélection, étage dans lequel, entre la base du deuxième transistor et une source de courant auxiliaire d'intensité comprise entre celles du deuxième et du premier courant, sont disposées une première et une deuxième diode en série et dans le sens direct constituant une première branche, et dans lequel entre l'émetteur du deuxième transistor et ladite source de courant auxiliaire, est disposée une troisième diode dans le sens direct constituant une deuxième branche, de telle sorte que, lors de la commutation du signal de commande d'une dite ligne entre son niveau de sélection et son niveau de non-sélection, les charges stockées dans la base du second transistor soient évacuées par le courant de la source de courant auxiliaire dont la majeure partie passe dans la première branche, chaque ligne de la mémoire présentant un conducteur de ligne inférieur connecté à une source de courant de maintien, les cellules de mémoire de ladite ligne étant connectées entre les conducteurs de ligne supérieur et inférieur correspondants.

Une telle mémoire est décrite dans la demande de brevet européen n° 200 255 déposée par la Demanderesse le 14 avril 1986 sous le titre "Etage de commutation de type Darlington notamment pour un décodeur de lignes d'une mémoire".

Les mémoires qu'envisage essentiellement cette antériorité sont essentiellement les mémoires rapides comportant un nombre réduit de lignes.

Cependant, il peut être également intéressant de mettre en oeuvre un étage de commutation de type Darlington tel que décrit pour d'autres types de mémoires dont le temps de commutation est plus long, de manière à améliorer la désélection des lignes et en raison également de l'avantage supplémentaire consistant en le maintien d'un écart plus important entre le niveau correspondant au mode sélectionné et celui correspondant au mode non-sélectionné.

On connaît par ailleurs un circuit de décharge rapide par exemple du brevet US 4 168 490 (mise à la masse des lignes désélectionnées). La demande de brevet allemand DE-OS 2 658 523 propose une mémoire rapide mettant en oeuvre un décodeur à diodes qui consomme peu de courant.

La Demanderesse a alors constaté que, dans certains cas, un disfonctionnement pouvait se produire au niveau des lignes désélectionnées d'une mémoire à charge active (ECL) ou à charge résistive selon la demande de brevet européen 200 255.

Ce disfonctionnement consiste en la mise en saturation inverse d'un transistor d'une demi-cellule de chaque cellule de la ou des lignes désélectionnées. Ce phénomène est extrêmement gênant, car si le transistor pnp d'une demi-cellule ECL est notoirement lent à se désaturer en mode de saturation normale, c'est-à-dire directe, il est encore plus lent à se désaturer en mode de saturation inverse. Il est en outre paradoxal en ce sens que l'amélioration de la vitesse de désélection des lignes d'une mémoire est toujours considérée comme avantageuse. Dans le cas d'une mémoire à charge résistive la mise en inverse du transistor npn d'une demi-cellule est également un inconvénient.

Le Demanderesse a pu identifier la cause de ce dysfonctionnement. Il est en effet dû au fait que, lorsque la cellule présente une constante de temps de commutation intrinsèque notablement plus long que la constante de temps de désélection des lignes, il peut en résulter transitoirement que le niveau de son conducteur de ligne supérieur se retrouve plus bas que le niveau haut interne de la cellule mémoire et même dans certains cas plus bas que le niveau de son conducteur de ligne inférieur d'où passage dans le premier cas du transistor pnp d'une demi-cellule ECL en régime de saturation inverse et dans le deuxième cas d'une demi-cellule complète en régime direct inverse.

L'invention a pour but de remédier à cet inconvénient tout en conservant l'avantage d'une vitesse élevée de désélection de la ligne sélectionnée.

Dans ce but, ladite mémoire est caractérisée en ce qu'elle comporte une source de courant de décharge reliée aux conducteurs de lignes inférieurs à travers, pour chaque ligne, un circuit retardateur dont la constante de temps est inférieure au temps de commutation intrinsèque d'une cellule de mémoire et au moins égale à la constante de temps de désélection d'un conducteur de ligne supérieur.

Lors de la désélection d'une ligne, le courant fourni par la source de courant de décharge continue transitoirement, du fait du retard introduit, à passer par les conducteurs de ligne de la ligne désélectionnée. Ceci revient à augmenter la vitesse de commutation des cellules de mémoire.

Selon un mode de réalisation préféré, la constante de temps du circuit retardateur est choisie de manière que le temps de commutation apparent d'une cellule de mémoire soit minimisé.

Un dit circuit retardateur peut avantageusement être constitué par un transistor dit de ligne monté en diode par pontage entre sa base et son collecteur par une résistance de ligne, le collecteur dudit transistor de ligne étant connecté au conducteur de ligne inférieur de la ligne correspondante, et les émetteurs des transistors de ligne étant connectés à ladite source de courant de décharge.

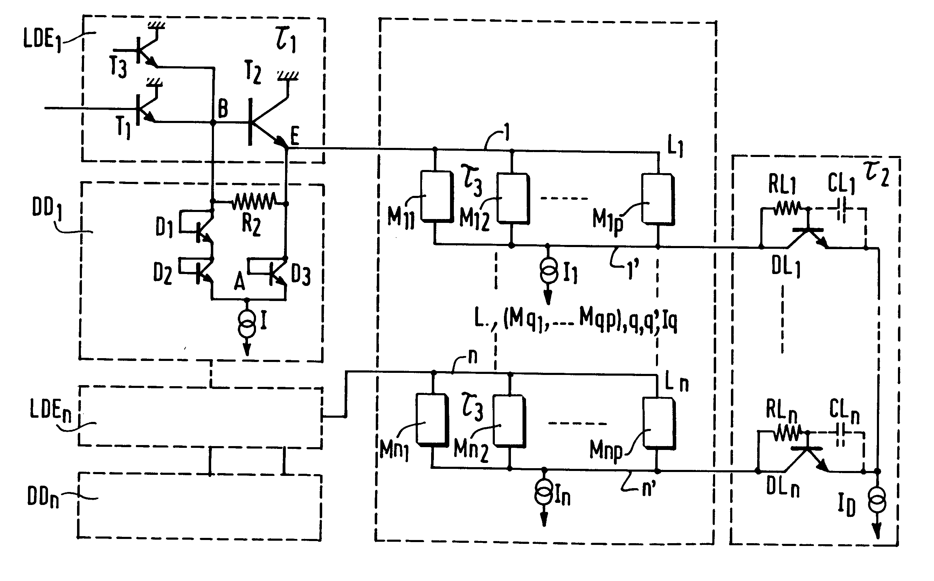

L'invention sera mieux comprise à la lecture de la description qui va suivre, donnée à titre d'exemple non limitatif, en liaison avec la figure unique qui représente une mémoire selon un mode de réalisation de l'invention, correspondant à une logique à émetteurs couplés et à charge active (ECL).

Chaque ligne de mémoire ($L_1$... $L_n$) comporte un étage de commutation de ligne ($LDE_1$...$LDE_n$) qui lui est associé. A chaque étage de commutation de ligne, est associé un circuit de décharge dynamique ($DD_1$...$DD_n$) permettant d'accélérer la désélection d'une ligne.

L'entrée de chaque étage de commutation de ligne ($LDE$...$LDE_n$) s'effectue sur la base d'un transistor $T_1$. Lorsque la ligne est sélectionnée, la base du transistor $T_1$ correspondant est au potentiel de la masse, et à un potentiel négatif déterminé lorsque la ligne est non-sélectionnée (niveau bas).

Chaque transistor $T_1$ attaque la base d'un transistor de sortie $T_2$ de grandes dimensions relativement à $T_1$, ayant son collecteur connecté à la masse et son émetteur au conducteur de ligne supérieur (1,....n) correspondant.

Lorsque la ligne $L_q$ est sélectionnée, celle des mémoires ($Mq_1$...$Mq_p$) qui est elle-même sélectionnée par des conducteurs de colonne (non représentés) est traversée par un courant de sélection $I_S$ relativement important et les autres cellules par un courant de maintien fourni par une source de courant Iq connectée au conducteur de ligne inférieur q'.

Pour les autres lignes, non sélectionnées, les cellules sont traversées seulement par le courant de maintien fourni par des sources de courant ($I_1$...$I-q_1$, $Iq_{11}$...$In$) appropriées (par exemple de 300 microampères chacune) connectées aux conducteurs de ligne inférieurs correspondants (1'..q'-1, q'...n').

Lors d'une désélection de la ligne $L_q$, le transistor $T_2$ voit son courant chuter de $I_S$ à Iq.

Cette chute de courant est accélérée par le circuit de décharge dynamique DDq qui lui est associé. Celui-ci comporte une source de courant I connectée en un point A. Soit B la base du transistor $T_2$ et E son émetteur. Entre les points B et A sont connectés dans le sens direct deux diodes $D_1$ et $D_2$ formant une première branche, et entre les points E et A une diode $D_3$ également dans le sens direct et formant une deuxième branche. Lors d'une désélection de la ligne, les charges stockées dans la base du transistor $T_2$ sont évacuées par le courant I dont la majeure partie passe dans la première branche.

En mode non-sélectionné, la majeure partie du courant I passe dans la deuxième branche.

Pour plus de détail sur le fonctionnement de ce circuit de décharge dynamique, on se reportera à la demande de brevet précitée déposée par la Demanderesse.

Ainsi qu'il a été mentionné ci-dessus, dans le cas où le temps de commutation intrinsèque $\tau_3$ d'une cellule de mémoire ($M_{11}$....$Mnp$) est notablement supérieur au temps de désélection $\tau_1$ d'une ligne, il peut en résulter transitoirement que le niveau de son conducteur de ligne supérieur soit plus bas que le niveau haut interne d'une cellule mémoire, d'où passage du transistor pnp d'une demi-cellule ECL en régime de saturation inverse.

Dans certains cas, le niveau du conducteur de ligne supérieur peut devenir plus bas que le niveau du conducteur de ligne inférieur, d'où fonctionnement d'une demi-cellule en régime direct inverse.

Le principe de base de l'invention consiste à fournir transitoirement un courant de décharge $I_D$ au conducteur de ligne inférieur q' de la ligne $L_q$ qui se désélectionne de manière à accélérer la commutation des cellules.

Pour cela une source de courant $I_D$ est reliée à chacun des conducteurs de ligne inférieur (1'...n') à travers un circuit retardateur ($DL_1$...$DL_n$).

Selon la figure, un circuit retardateur comporte un transistor monté en diode ($DL_1$...$DL_n$) par pontage entre sa base et son collecteur par une résistance ($RL_1$...$RL_n$).

La constante de temps $\tau_2$ de ce circuit est le produit de la résistance ($RL_1$...$RL_n$) correspondante par la capacité $C_{BE}$ du transistor correspondant ($DL_1$...$DL_n$). Cette constante de temps $\tau_2$ peut éventuellement être augmentée par adjonction d'une capacité supplémentaire ($CL_1$...$CL_n$) entre la base et l'émetteur du transistor correspondant ($DL_1$...$DL_n$).

Lorsque la ligne $L_q$ est sélectionnée, son conducteur de ligne inférieur q' est à un niveau supérieur à celui des autres conducteurs de ligne inférieure et le courant $I_D$ vient s'ajouter au courant Iq. Lorsque la ligne $L_q$ se désélectionne, la contribution du courant $I_D$ à la ligne $L_q$ est transitoirement maintenue en raison de la constante de temps $\tau_2$ introduite.

La constante de temps $\tau_2$ des circuits retardateurs doit être choisie inférieure à la constante de temps de commutation intrinsèque $\tau_3$ des cellules de mémoire ($M_{11}$...$Mnp$). Ce temps $\tau_3$ est défini comme le temps de commutation desdites cellules en l'absence des circuits retardateurs.

La constante de temps $\tau_2$ doit être également choisie supérieure ou égale à la constante de temps $\tau_1$ de désélection des lignes.

Lors de la désélection d'une ligne, le courant de décharge $I_D$ vient s'ajouter transitoirement au courant qui traverse les cellules de manière à accélérer leur commutation.

Il en résulte que le temps de commutation apparent $\tau'_3$ des cellules devient inférieur au temps intrinsèque $\tau_3$ défini ci-dessus. Cette amélioration des performances dynamiques des cellules est de nature à empêcher leur mise en saturation inverse ou en régime direct inverse.

La constante de temps $\tau_2$ est choisie de préférence de manière à minimiser le temps $\tau'_3$. On peut en effet montrer que la fonction liant $\tau'_3$ à $\tau_2$ passe par un minimum et que par conséquent, diminuer $\tau_2$ au delà d'une certaine valeur n'apporte plus d'amélioration.

En ce qui concerne le courant $I_D$ sa valeur sera choisie de manière à ne pas trop diminuer la vitesse d'écriture de la cellule.

Exemple :

$\tau_1 = 0,4$ ns     $\tau_2 = 0,5$ ns
$\tau_3 = 1,3$ ns     $\tau'_3 = 0,9$ ns
avec $I_D = 1$mA
et $I_1,...,I_n = 300\mu$A.

**Revendications**

1. Mémoire comportant un décodeur de ligne ($LDE_1...LDE_n$) pourvu pour chaque ligne d'un étage de commutation du type Darlington comportant un premier transistor ($T_1$) dont la base, qui constitue l'entrée de l'étage, est susceptible de recevoir un signal logique de commande dont la tension varie entre un niveau dit de sélection et un niveau dit de non-sélection, et dont l'émetteur attaque la base d'un deuxième transistor ($T_2$) dont l'émetteur, qui constitue la sortie de l'étage, est relié à un conducteur de ligne supérieur (1...n) dans lequel circule un premier courant lorsque ledit signal logique de commande est à son niveau de sélection et un deuxième courant plus faible que le premier lorsque ledit signal logique de commande est à son niveau de non-sélection, étage dans lequel, entre la base du deuxième transistor ($T_2$) et une source de courant auxiliaire (I) d'intensité comprise entre celles du deuxième et du premier courant, sont disposées une première ($D_1$) et une deuxième ($D_2$) diode en série et dans le sens direct constituant une première branche, et dans lequel entre l'émetteur du deuxième transistor ($T_2$) et ladite source de courant auxiliaire (I), est disposée une troisième diode ($D_3$) dans le sens direct constituant un deuxième branche, de sorte que, lors de la commutation du signal de commande d'une dite ligne ($L_1...L_n$) entre son niveau de sélection et son niveau de non-sélection, les charges stockées dans la base du second transistor ($T_2$) soient évacuées par le courant de la source de courant auxiliaire (I) dont la majeure partie passe dans la première branche, chaque ligne ($L_1...L_n$) de la mémoire présentant un conducteur de ligne inférieur (1'...n') connecté à une source de courant de maintien, les cellules mémoire de ladite ligne étant connectées entre les conducteurs de ligne supérieur (1...n) et inférieur (1'...n') correspondants, caractérisée en ce qu'elle comporte une source de courant de décharge ($I_D$) reliée aux conducteurs de ligne inférieurs (1'...n') à travers, pour chaque ligne, un circuit retardateur fournissant transitoirement un courant de décharge ($I_D$) au conducteur de ligne inférieur (1'...n') de la ligne ($L_1...L_n$) qui se désélectionne, le circuit retardateur ayant une constante de temps ($\tau_2$) qui est inférieure au temps de commutation intrinsèque ($\tau_3$) d'une cellule de mémoire ($M_{11}...Mnp$) et au moins égale à la constante de temps ($\tau_1$) de désélection d'un conducteur de ligne supérieur (1...n).

2. Mémoire selon la revendication 1 caractérisée en ce que la constante de temps ($\tau_2$) du circuit retardateur est choisie de manière que le temps de commutation apparent ($\tau'_3$) d'une cellule de mémoire ($M_{11}...Mnp$) soit minimisé.

3. Mémoire selon la revendication 2 caractérisée en ce qu'un dit circuit retardateur est constitué par un transistor dit de ligne monté en diode ($DL_1...DLn$) par pontage entre sa base et son collecteur par une résistance de ligne ($RL_1...RLn$), le collecteur dudit transistor de ligne étant connecté au conducteur de ligne inférieur (1'...n') de la ligne correspondante, et les émetteurs des transistors de ligne étant connectés à ladite source de courant de décharge ($I_D$).

4. Mémoire selon la revendication 3 caractérisée en ce que lesdits transistors de ligne comportent chacun un condensateur ($CL_1...CLn$) branché entre leur base et leur émetteur.

**Claims**

1. A memory, comprising a line decoder ($LDE_1..LDEn$) which comprises for each line a Darlington-type line switching stage, compris-

ing a first transistor (T$_1$) whose base forms the input of the stage and serves to receive a logic control signal whose voltage varies between a level which is referred to as the selection level and a level which is referred to as the non-selection level, its emitter being connected to the base of a second transistor (T$_2$) whose emitter constitutes the output of the stage and is connected to an upper line conductor (1..n) in which a first current flows when said logic control signal has the selection level whilst a second current which is smaller than the first current flows therein when said logic control signal has the non-selection level, in which stage there are arranged, between the base of the second transistor (T$_2$) and an auxiliary current source (I) for a current intensity between that of the second current and the first current, a first (D$_1$) and a second diode (D$_2$) which are connected in series and in the forward direction and which form a first branch, and in which stage there is also arranged, between the emitter of the second transistor (T$_2$) and said auxiliary current source (I), a third diode (D$_3$) which is connected in the forward direction and which constitutes a second branch so that, when the control signal of a said line (L$_1$..Ln) is switched between its selection level and its non-selection level, the charges stored in the base of the second transistor (T$_2$) are drained by the current of the auxiliary current source (I), the major part of which enters the first branch, each line (L$_1$..Ln) of the memory comprising a lower line conductor (1'..n') which is connected to a sustaining current source, the memory cells of said line being connected between the corresponding upper (1..n) and lower (1'..n') line conductors, characterized in that it comprises a discharge current source (I$_D$) which is connected to the lower line conductors (1'..n') *via,* for each line, a delay circuit which temporarily applies a discharge current (I$_D$) to the lower line conductor (1'..n') of the line (L$_1$..Ln) which is being deselected, the delay circuit having a time constant ($\tau_2$) which is smaller than the intrinsic switching time ($\tau_3$) of a memory cell (M$_{11}$..Mnp) and at least equal to the deselection time constant ($\tau_1$) of an upper line conductor (1..n).

2. A memory as claimed in Claim 1, characterized in that the time constant ($\tau_2$) of the delay circuit is chosen so that the apparent switching time ($\tau'_3$) of a memory cell (M$_{11}$..Mnp) is minimized.

3. A memory as claimed in Claim 2, characterized in that a said delay circuit is formed by a so-called line transistor which is connected as a diode (DL$_1$..DLn) by bridging its base and its collector by means of a line resistor (RL$_1$..RLn), the collector of said line transistor being connected to the lower line conductor (1'..n') of the corresponding line, the emitters of the line transistors being connected to said discharge current source (I$_D$).

4. A memory as claimed in Claim 3, characterized in that each of said line transistors comprises a capacitor (CL$_1$..CLn) which is connected between their base and their emitter.

**Patentansprüche**

1. Speicher mit einem Zeilendecoder (LDE$_1$...LDE$_n$) für jede Zeile einer Darlington-Schaltstufe, die einen ersten Transistor (T$_1$) enthält, dessen den Stufeneingang bildende Basis ein logisches Steuersignal empfangen kann, dessen Spannung zwischen einem sog. Wählpegel und einem sog. Nichtwählpegel schwankt, und dessen Emitter die Basis eines zweiten Transistors (T$_2$) ansteuert, dessen Emitter als Ausgang der Stufe mit einem oberen Zeilenleiter (1...n) verbunden ist, in dem ein erster Strom umläuft, wenn das logische Steuersignal auf dem Wählpegel liegt, und in dem ein zweiter Strom schwächer als der erste umläuft, wenn das logische Steuersignal auf dem Nichtwählsignal liegt, in welcher Stufe zwischen der Basis des zweiten Transistors (T$_2$) und einer Hilfsstromquelle (I) mit einer Stromstärke zwischen denen des ersten und des zweiten Stroms eine erste Diode (D$_1$) und eine zweite Diode (D$_2$) in Reihenschaltung und in Durchlaßrichtung angeordnet sind, die zusammen einen ersten Abzweig bilden, und in dem zwischen dem Emitter des zweiten Transistors (T$_2$) und der Hilfsstromquelle (I) eine dritte Diode (D$_3$) in Durchlaßrichtung als zweiter Abzweig derart angeordnet ist, daß, wenn das Umschalten des Steuersignals einer gegebenen Leitung (L$_1$...Ln) zwischen ihrem Wählpegel und ihrem Nichtwählpegel erfolgt, die in der Basis des zweiten Transistors (T$_2$) gespeicherten Ladungen durch den Strom der Hilfsstromquelle (I) abgezogen werden, von dem der größere Teil in den ersten Abzweig eingegeben wird, wobei jede Zeile (L$_1$...L$_n$) des Speichers einen mit einer Haltestromquelle verbundenen niederen Zeilenleiter (1'...n') darstellt, und die Speicherzellen der Zeile zwischen den entsprechenden höheren (1...n) und niederen (1'...n') Zeilenleitern angeschlossen sind, dadurch gekennzeichnet, daß der Speicher eine für jede Zeile quer mit den niederen Zeilenleitern verbundene Entladungsstromquelle ($I_D$) enthält, wobei ein Verzögerungskreis den niederen Zeilenleiter (1'...n') der Zeile ($L_1...L_n$), die sich der Wahl entzieht, mit einem Entladungsstrom ($I_D$) beliefert, und der Verzögerungskreis eine Zeitkonstante ($\tau_2$) besitzt, die niedriger als der eine Speicherzelle ($M_{11}...Mnp$) eigene Schaltvorgang ($\tau_3$) und wenigstens gleich der Nichtwähl-Zeitkonstante ($\tau_1$) eines höheren Zeilenleiters (1...n) ist.

2. Speicher nach Anspruch 1,
dadurch gekennzeichnet, daß die Zeitkonstante ($\tau_2$) des Verzögerungskreises derart gewählt wird, daß die offensichtliche Schaltzeit ($\tau_3$) der Speicherzelle ($M_{11}...Mnp$) minimisiert werden muß.

3. Speicher nach Anspruch 2,
dadurch gekennzeichnet, daß ein gegebener Verzögerungskreis aus einem sog. Zeilentransistor besteht, der durch Überbrückung zwischen seiner Basis und seinem Kollektor mit einem Zeilenwiderstand ($RL_1...RLn$) als Diode ($DL_1...DLn$) geschaltet ist, wobei der Kollektor des Zeilentransistors an den niederen Zeilenleiter (1'...n') der entsprechenden Zeile angeschlossen ist, und die Emitter der Zeilentransistoren an die Entladungsstromquelle ($I_D$) angeschlossen sind.

4. Speicher nach Anspruch 3,
dadurch gekennzeichnet, daß die Zeilentransistoren je einen zwischen ihrer Basis und ihrem Emitter eingeschalteten Kondensator ($CL_1...CLn$) enthalten.

EP 0 289 063 B1